(19) Europäisches Patentamt / European Patent Office / Office européen des brevets

(11) **EP 4 481 833 A1**

(12) **EUROPEAN PATENT APPLICATION**
published in accordance with Art. 153(4) EPC

(43) Date of publication:
**25.12.2024 Bulletin 2024/52**

(21) Application number: **23756268.1**

(22) Date of filing: **09.02.2023**

(51) International Patent Classification (IPC):
***H01L 31/0248*** *(2006.01)*

(52) Cooperative Patent Classification (CPC):
**H01L 31/0248**

(86) International application number:
**PCT/JP2023/004271**

(87) International publication number:
**WO 2023/157742 (24.08.2023 Gazette 2023/34)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **18.02.2022 JP 2022023986**
**09.12.2022 JP 2022197039**

(71) Applicant: **FUJIFILM Corporation**
**Tokyo 106-8620 (JP)**

(72) Inventor: **SAWAMURA, Yasuhiro**
**Haibara-gun, Shizuoka 421-0396 (JP)**

(74) Representative: **HGF**
**HGF Limited**
**1 City Walk**
**Leeds LS11 9DX (GB)**

# (54) DISPERSION LIQUID, METHOD FOR PRODUCING QUANTUM DOT FILM, METHOD FOR PRODUCING PHOTO-DETECTION ELEMENT, AND METHOD FOR PRODUCING IMAGE SENSOR

(57) There is provided a dispersion liquid containing a quantum dot having a band gap of 1.35 eV or less, two or more kinds of ligands, and a solvent, in which at least one of the two or more kinds of ligands is a ligand having a boiling point of 200°C or lower. There are also provided manufacturing methods for a quantum dot film using a dispersion liquid, a photodetection element, and an image sensor.

FIG. 1

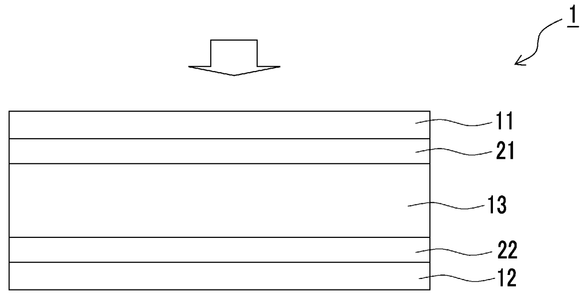


EP 4 481 833 A1

## Description

## BACKGROUND OF THE INVENTION

1. Field of the Invention

The present invention relates to a dispersion liquid containing quantum dots. In addition, the present invention relates to manufacturing methods for a quantum dot film, a photodetection element, and an image sensor.

2. Description of the Related Art

In recent years, attention has been focused on photodetection elements capable of detecting light in the infrared region in the fields such as smartphones, surveillance cameras, and in-vehicle cameras.

In the related art, a silicon photodiode in which a silicon wafer is used as a material of a photoelectric conversion layer has been used in a photodetection element that is used for an image sensor or the like. However, a silicon photodiode has low sensitivity in the infrared region having a wavelength of 900 nm or more.

In addition, an InGaAs-based semiconductor material known as a near-infrared light-receiving element has a problem in that it requires extremely high-cost processes such as epitaxial growth or a step of sticking a substrate in order to realize a high quantum efficiency, and thus it has not been widespread.

In addition, in recent years, the use of the quantum dot for a photoelectric conversion element has been being studied. For example, Patent Literature 1 describes that a quantum dot having inorganic particles is used for a photoelectric conversion layer of a photoelectric conversion element, where the quantum dot is such that the quantum dot has an organic ligand and an inorganic ligand on a surface thereof, and a molar ratio of the inorganic ligand to a total of the inorganic ligand and the organic ligand is 25% or more and 99.8% or less.

[CITATION LIST]

[Patent Literature]

Patent Literature 1: JP2020-150251A

## SUMMARY OF THE INVENTION

In recent years, with the demand for performance improvement of an image sensor and the like, there is a demand for further improvement of various characteristics that are required in a photodetection element used in the image sensor and the like. For example, as the characteristics required for the photodetection element, it is required to have a high external quantum efficiency with respect to light having a target wavelength to be detected by the photodetection element.

On the other hand, in general, a ligand having a long molecular chain length, such as oleic acid, is used for a dispersion liquid of quantum dots in order to improve the dispersibility of the quantum dots in the dispersion liquid. However, in a case where a quantum dot film such as a photoelectric conversion layer is formed by using a dispersion liquid containing such a ligand having a long molecular chain length, the distance between the quantum dots tends to be long, sufficient light responsiveness is not obtained, and thus the external quantum efficiency tends to be low.

Therefore, after forming a film using a dispersion liquid of quantum dots, a ligand solution is applied onto the film to exchange the ligand coordinated to the quantum dots in the film with another ligand. Also in JP2020-150251A, after forming a film using a dispersion liquid of quantum dots, a ligand solution is applied onto the film to exchange the ligand.

As described above, in the dispersion liquid of quantum dots known so far, it is necessary to carry out a ligand exchange treatment in order to form a quantum dot film having a high external quantum efficiency, which is time-consuming and results in an increase in cost.

Therefore, an object of the present invention is to provide a dispersion liquid which has excellent dispersibility and makes it possible to form a quantum dot film having a high external quantum efficiency. In addition, another object of the present invention is to provide manufacturing methods for a quantum dot film, a photodetection element, and an image sensor.

The present invention provides the following aspects.

<1> A dispersion liquid comprising:

a quantum dot having a band gap of 1.35 eV or less;

two or more kinds of ligands; and
a solvent,
in which at least one of the two or more kinds of ligands is a ligand having a boiling point of 200°C or lower.

<2> The dispersion liquid according to <1>, in which a difference between a boiling point of a ligand having a lowest boiling point and a boiling point of a ligand having a highest boiling point among the two or more kinds of ligands is 30°C or higher.
<3> The dispersion liquid according to <1> or <2>, in which the ligand having a boiling point of 200°C or lower is an organic ligand.
<4> The dispersion liquid according to <3>, in which the organic ligand is a compound having at least one functional group selected from the group consisting of a carboxy group, a mercapto group, an amino group, a phospho group, a phosphonate group, a sulfonamide group, a sulfonimide group, and a sulfo group.
<5> The dispersion liquid according to any one of <1> to <4>, in which the dispersion liquid contains a ligand having a boiling point of 200°C or lower and a ligand having a boiling point of higher than 200°C.
<6> The dispersion liquid according to <5>, in which the ligand having a boiling point of higher than 200°C is an organic ligand.
<7> The dispersion liquid according to <6>, in which the organic ligand is a compound having at least one functional group selected from the group consisting of a carboxy group, a mercapto group, an amino group, a phospho group, a phosphonate group, a sulfonamide group, a sulfonimide group, and a sulfo group.
<8> The dispersion liquid according to <5>, in which the ligand having a boiling point of higher than 200°C is an inorganic ligand.
<9> The dispersion liquid according to any one of <1> to <8>, in which a content of the quantum dot in a component obtained by removing the solvent and the ligand from the dispersion liquid is 50% by mass or more.
<10> The dispersion liquid according to any one of <1> to <9>, in which the quantum dot contains at least one kind of atom selected from the group consisting of Ga, Ge, As, Se, In, Sn, Sb, Te, Pb, Bi, Ag, Cu, and Hg.
<11> The dispersion liquid according to any one of <1> to <9>, in which the quantum dot contains at least one kind of atom selected from the group consisting of Ga, As, Se, In, Sb, Te, and Bi.
<12> The dispersion liquid according to any one of <1> to <11>, in which the quantum dot has a maximal absorption in terms of absorbance in a wavelength range of 900 to 1,700 nm.
<13> The dispersion liquid according to any one of <1> to <12>, in which the dispersion liquid is used for a photoelectric conversion layer of an infrared sensor.
<14> A manufacturing method for a quantum dot film, comprising:

applying the dispersion liquid according to any one of <1> to <13> onto a support to form a composition layer; and
drying the composition layer.

<15> A manufacturing method for a photodetection element, comprising:
the manufacturing method for a quantum dot film according to <14>.
<16> A manufacturing method for an image sensor, comprising:
the manufacturing method for a quantum dot film according to <14>.

According to the present invention, it is possible to provide a dispersion liquid which has excellent dispersibility and makes it possible to form a quantum dot film having a high external quantum efficiency. In addition, it is possible to provide manufacturing methods for a quantum dot film, a photodetection element, and an image sensor.

## BRIEF DESCRIPTION OF THE DRAWINGS

Fig. 1 is a view illustrating an embodiment of a photodetection element.

## DESCRIPTION OF THE PREFERRED EMBODIMENTS

Hereinafter, the contents of the present invention will be described in detail.
In the present specification, "to" is used to mean that numerical values described before and after "to" are included as a lower limit value and an upper limit value, respectively.
In describing a group (an atomic group) in the present specification, in a case where a description of substitution and non-substitution is not provided, the description means the group includes a group (an atomic group) having a substituent as well as a group (an atomic group) having no substituent. For example, the "alkyl group" includes not only an alkyl group that does not have a substituent (an unsubstituted alkyl group) but also an alkyl group that has a substituent (a

substituted alkyl group).

<Dispersion liquid>

A dispersion liquid according to an embodiment of the present invention is characterized by containing a quantum dot having a band gap of 1.35 eV or less, two or more kinds of ligands, and a solvent, where at least one of the two or more kinds of ligands is a ligand having a boiling point of 200°C or lower.

Since the dispersion liquid according to the embodiment of the present invention contains two or more kinds of ligands, the dispersibility of the quantum dots is excellent, and it is possible to suppress the occurrence of aggregation of the quantum dots even after long-term storage. In addition, since the dispersion liquid according to the embodiment of the present invention contains a ligand (hereinafter, also referred to as a first ligand) having a boiling point of 200°C or lower, at least a part of the first ligands having a low boiling point are removed during film formation, and thus the distance between the quantum dots can be made closer. Therefore, in a case where the dispersion liquid according to the embodiment of the present invention is used, it is possible to form a quantum dot film having a high external quantum efficiency without carrying out a ligand exchange step.

The quantum dot film obtained by using the dispersion liquid according to the embodiment of the present invention can be used for a photodetection element or an image sensor. More specifically, the quantum dot film can be used for a photoelectric conversion layer of a photodetection element or an image sensor. Therefore, the dispersion liquid according to the embodiment of the present invention is preferably used for a photoelectric conversion layer of a photodetection element or an image sensor.

In addition, since the dispersion liquid according to the embodiment of the present invention contains the above-described quantum dots, the quantum dot film obtained by using the dispersion liquid according to the embodiment of the present invention has excellent sensitivity to light having a wavelength in the infrared range. Therefore, the image sensor in which the quantum dot film obtained by using the dispersion liquid according to the embodiment of the present invention is used for the photoelectric conversion layer can be particularly preferably used as an infrared sensor. Therefore, the dispersion liquid according to the embodiment of the present invention is preferably used as a dispersion liquid for a photoelectric conversion layer of an infrared sensor.

Hereinafter, the dispersion liquid according to the embodiment of the present invention will be described in more detail.

(Quantum dot)

The dispersion liquid according to the embodiment of the present invention contains quantum dots. The quantum dot is preferably a semiconductor particle containing a metal atom. It is noted that in the present specification, the metal atom also includes a metalloid atom represented by a Si atom. In addition, the "semiconductor" in the present specification means a substance having a specific resistance value of $10^{-2}$ $\Omega$cm or more and $10^{8}$ $\Omega$cm or less.

Examples of the quantum dot material that constitutes the quantum dot include a nanoparticle (a particle having a size of 0.5 nm or more and less than 100 nm) of a general semiconductor crystal [a) a Group IV semiconductor, b) a compound semiconductor of a Group IV to IV element, a Group III to V element, or a Group II to VI element, or c) a compound semiconductor consisting of a combination of three or more of a Group II element, a Group III element, a Group IV element, a Group V element, and a Group VI element].

The quantum dot is preferably a quantum dot that contains at least one kind of atom selected from the group consisting of Ga, Ge, As, Se, In, Sn, Sb, Te, Pb, Bi, Ag, Cu, and Hg, and it is more preferably such one that contains at least one kind of atom selected from the group consisting of Ga, As, Se, In, Sb, Te, and Bi. In addition, it is also preferable that the quantum dot contains a Pb atom.

Specific examples of the quantum dot material constituting the quantum dot include semiconductor materials having a relatively narrow band gap, such as PbS, PbSe, PbSeS, InN, Ge, InAs, InGaAs, CuInS, CuInSe, CuInGaSe, InSb, HgTe, HgCdTe, $Ag_2S$, $Ag_2Se$, $Ag_2Te$, SnS, SnSe, SnTe, Si, InP, $AgBiS_2$, and AgBiSTe. Due to the reason that the absorption coefficient of light in the infrared range is large, the lifetime of photocurrent is long, the carrier mobility is large, and the like, the quantum dot is preferably PbS, InAs, $AgBiS_2$, or AgBiSTe.

The band gap of the quantum dot is 1.35 eV or less, and it is preferably 1.1 eV or less and more preferably 1.0 eV or less. The lower limit value of the band gap of the quantum dot is not particularly limited; however, it can be set to 0.5 eV or more. In a case where the band gap of the quantum dot is 1.35 eV, it is possible to form a quantum dot film having a higher external quantum efficiency with respect to light having a wavelength in the infrared range. The band gap of the quantum dot can be calculated from the energy at the maximal absorption wavelength in an absorption spectrum obtained from light absorption measurement in a range from the visible range to the infrared range, by using an ultraviolet-visible-near infrared spectrophotometer. In addition, it can be determined from a Tauc plot as described in JP5949567B in a case of a quantum dot having no maximal absorption wavelength.

The quantum dot is preferably a quantum dot that has a maximal absorption in terms of absorbance in a wavelength range of 900 to 1,700 nm, and it is more preferably such one that has a maximal absorption in terms of absorbance in a wavelength range of 1,300 to 1,600 nm. In a case where such quantum dots are uesd, it is possible to form a quantum dot film having a higher external quantum efficiency with respect to light having a wavelength in the infrared range.

The quantum dot is also preferably a quantum dot that has high absorption with respect to light having any wavelength in a wavelength range of 900 to 1,700 nm (preferably, a wavelength range of 1,300 to 1,600 nm). In a case where such quantum dots are uesd, it is possible to form a quantum dot film having a higher external quantum efficiency with respect to light having a wavelength in the infrared range.

The average particle diameter of the quantum dots is preferably 3 to 20 nm. The lower limit value of the average particle diameter of the quantum dots is preferably 4 nm or more and more preferably 5 nm or more. The upper limit value of the average particle diameter of the quantum dots is preferably 15 nm or less and more preferably 10 nm or less. In a case where the average particle diameter of the quantum dots is in the above-described range, it is possible to form a quantum dot film having a higher external quantum efficiency with respect to light having a wavelength in the infrared range. It is noted that in the present specification, the value of the average particle diameter of the quantum dots is an average value of the particle diameters of ten quantum dots which are randomly selected. A transmission electron microscope may be used for measuring the particle diameter of the quantum dots.

The content of the quantum dot in the dispersion liquid is preferably 1% to 25% by mass with respect to the total mass of the dispersion liquid. The lower limit thereof is preferably 2% by mass or more and more preferably 3% by mass or more. The upper limit thereof is preferably 20% by mass or less.

In addition, the content of the quantum dot in the dispersion liquid is preferably 10 to 250 mg/mL. The lower limit thereof is preferably 20 mg/mL or more and more preferably 30 mg/mL or more. The upper limit thereof is preferably 200 mg/mL or less.

In addition, a content of the quantum dot in a component obtained by removing the solvent and the ligand from the dispersion liquid is preferably 50% by mass or more, more preferably 60% by mass or more, and still more preferably 70% by mass or more. The upper limit thereof may be 100% by mass or less.

In addition, a total content of the quantum dot and the ligand in a component obtained by removing the solvent from the dispersion liquid is preferably 60% by mass or more, more preferably 70% by mass or more, and still more preferably 80% by mass or more. The upper limit thereof may be 100% by mass or less.

(Ligand)

The dispersion liquid according to the embodiment of the present invention contains two or more kinds of ligands, and at least one of the two or more kinds of ligands is a ligand having a boiling point of 200°C or lower. It is noted that in the present specification, the value of boiling point is a value at 1 atm.

A difference between a boiling point of a ligand having the lowest boiling point (hereinafter, also referred to as a ligand L) and a boiling point of a ligand having the highest boiling point (hereinafter, also referred to as a ligand H) among the two or more kinds of ligands contained in the dispersion liquid is preferably 30°C or higher, more preferably 35°C or higher, and still more preferably 40°C or higher. In a case where the difference in boiling point is 30°C or more, it is possible to expect an effect that the ligand L can be volatilized to bring the quantum dots closer to each other while suppressing the volatilization of the ligand H during film formation.

The boiling point of the ligand L is preferably 200°C or lower, more preferably 190°C or lower, and still more preferably 180°C or lower. The lower limit thereof is preferably 60°C or higher, more preferably 70°C or higher, and still more preferably 80°C or higher.

The ligand L is preferably an organic ligand. Examples of the organic ligand to be used as the ligand L include materials described in the first ligand described later.

The ligand H may be an organic ligand or may be an inorganic ligand. Due to the reason that it is possible to form a quantum dot film that has a higher external quantum efficiency with respect to light having a wavelength in the infrared range and has a smaller dark current, the ligand H is preferably an inorganic ligand. Examples of the inorganic ligand and the organic ligand which are used as the ligand H include materials described in the second ligand described later.

The content of the ligand H is preferably 1 to 400 parts by mass with respect to 100 parts by mass of the ligand L. The lower limit thereof is preferably 5 parts by mass or more and more preferably 10 parts by mass or more. The upper limit thereof is preferably 200 parts by mass or less and more preferably 150 parts by mass or less.

The two or more kinds of ligands contained in the dispersion liquid may be ligands each having a boiling point of 200°C or lower; however, it is preferable that the dispersion liquid contains a ligand having a boiling point of 200°C or lower and a ligand having a boiling point of higher than 200°C due to the reason that the generation of surface defects of the quantum dot is suppressed, whereby it is possible to form a quantum dot film that has a higher external quantum efficiency with respect to light having a wavelength in the infrared range and has a smaller dark current. Hereinafter, the ligand having

a boiling point of 200°C or lower is also referred to as a first ligand. In addition, the ligand having a boiling point of 200°C or lower is also referred to as a second ligand.

In a case where the dispersion liquid according to the embodiment of the present invention contains the first ligand and the second ligand, the content of the second ligand is preferably 1 to 400 parts by mass with respect to 100 parts by mass of the first ligand. The lower limit thereof is preferably 5 parts by mass or more and more preferably 10 parts by mass or more. The upper limit thereof is preferably 200 parts by mass or less and more preferably 150 parts by mass or less.

The boiling point of the first ligand is preferably 60°C to 200°C. The upper limit thereof is preferably 190°C or lower and more preferably 180°C or lower. The lower limit thereof is preferably 70°C or higher and more preferably 80°C or higher.

The first ligand is preferably an organic ligand. In addition, the organic ligand is preferably a compound having at least one functional group selected from the group consisting of a carboxy group, a mercapto group, an amino group, a hydroxy group, a phospho group, a phosphonate group, a sulfonamide group, a sulfonimide group, and a sulfo group, more preferably a compound having at least one functional group selected from the group consisting of a carboxy group, a mercapto group, an amino group, a phospho group, a phosphonate group, a sulfonamide group, a sulfonimide group, and a sulfo group, and still more preferably a compound having at least one functional group selected from the group consisting of a mercapto group and an amino group.

The organic ligand to be used as the first ligand may be a monodentate organic ligand or may be a multidentate organic ligand having two or more coordination moieties; however, it is preferably a monodentate organic ligand due to the reason that the volatilization from the film during film formation is easy. Examples of the coordination moiety contained in the organic ligand include the above-described functional groups.

Specific examples of the first ligand include acetic acid, propionic acid, acrylic acid, methacrylic acid, crotonic acid, butyric acid, cyclopropanecarboxylic acid, isobutanoic acid, chloroacetic acid, trifluoroacetic acid, thioacetic acid, n-butylamine, sec-butylamine, tert-butylamine, amylamine, 1-hexylamine, cyclohexylamine, aminoethanol, 1-amino-2-propanol, 1-amino-3-propanol, aniline, 1-phenylethylamine, 2-methoxyethylamine, 2-ethoxyethylamine, 1,3-diaminopropane, N,N-dimethyl-1,3-propanediamine, 1-butanethiol, 1-hexanethiol, cyclohexanethiol, ethanedithiol, 1,3-propanedithiol, 2-mercaptoethanol, 3-mercaptopropanol, 6-mercaptohexanol, methyl thioglycolate, ethyl thioglycolate, thioglycolic acid, butyl thioglycolate, methyl 1-mercaptopropionate, 3-mercapto-2-butanone, and 3-mercapto-2-pentanone. In addition, specific examples of the first ligand also include a compound having a boiling point of 200°C or lower among specific examples of the multidentate organic ligand described later. The first ligand is preferably at least one selected from the group consisting of ethoxyethylamine, ethyl thioglycolate, butyl thioglycolate, and methyl 1-mercaptopropanoate.

The boiling point of the second ligand is higher than 200°C, and it is preferably 210°C or higher, more preferably 220°C or higher, and still more preferably 240°C or higher.

The second ligand may be an organic ligand or may be an inorganic ligand. Due to the reason that it is possible to form a quantum dot film that has a higher external quantum efficiency with respect to light having a wavelength in the infrared range and has a smaller dark current, the second ligand is preferably such one that includes an inorganic ligand. As the second ligand, an inorganic ligand and an organic ligand can be used in combination.

The inorganic ligand to be used as the second ligand is preferably an inorganic halide. Examples of the halogen atom contained in the inorganic halide include a fluorine atom, a chlorine atom, a bromine atom, and an iodine atom, where a bromine atom is preferable. In addition, the inorganic halide is preferably a compound containing at least one kind of atom selected from the group consisting of Ga, Ge, As, Se, In, Sn, Sb, Te, Tl, Pb, Bi, and Po.

Specific examples of the inorganic ligand include zinc iodide, zinc bromide, zinc chloride, indium iodide, indium bromide, indium chloride, cadmium iodide, cadmium bromide, and cadmium chloride, gallium iodide, gallium bromide, and gallium chloride, potassium sulfide, and sodium sulfide.

The organic ligand to be used as the second ligand is preferably a compound having at least one functional group selected from the group consisting of a carboxy group, a mercapto group, an amino group, a hydroxy group, a phospho group, a phosphonate group, a sulfonamide group, a sulfonimide group, and a sulfo group, more preferably a compound having at least one functional group selected from the group consisting of a carboxy group, a mercapto group, an amino group, a phospho group, a phosphonate group, a sulfonamide group, a sulfonimide group, and a sulfo group, and still more preferably a compound having at least one functional group selected from the group consisting of a mercapto group and an amino group.

The molecular weight of the organic ligand to be used as the second ligand is preferably 220 or less, more preferably 200 or less, and still more preferably 180 or less.

The organic ligand to be used as the second ligand may be a monodentate organic ligand; however, it is preferably a multidentate organic ligand containing two or more coordination moieties due to the reason that it is possible to form a quantum dot film that has a higher external quantum efficiency with respect to light having a wavelength in the infrared range and has a smaller dark current. Examples of the coordination moiety contained in the organic ligand include the above-described functional groups.

Examples of the monodentate organic ligand to be used as the second ligand include 2-naphthylamine, 4-methylthioaniline, 4-methylbenzenethiol, 3,5-dimethylbenzenethiol, 4-chlorobenzenethiol, 4-methoxybenzenethiol, benzoic acid, o-chlorobenzoic acid, m-chlorobenzoic acid, p-chlorobenzoic acid, p-fluorobenzoic acid, p-bromobenzoic acid, p-methylbenzoic acid, p-nitrobenzoic acid, p-cyanobenzoic acid, methanesulfonic acid, benzenesulfonic acid, p-toluenesulfonic acid, trifluoromethanesulfonamide, bistrifluoromethanesulfonylimide, dibenzenesulfonylimide, phosphoric acid, phenyl phosphate, ethyl phosphate, and phenyl phosphonate.

Examples of the multidentate ligand to be used as the first ligand or the second ligand include a ligand represented by any one of Formulae (A) to (C).

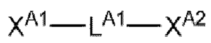

(A)

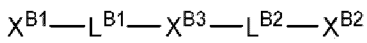

(B)

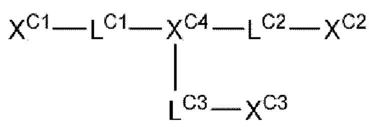

(C)

In Formula (A), $X^{A1}$ and $X^{12}$ each independently represent a carboxy group, a mercapto group, an amino group, a hydroxy group, a phospho group, a phosphonate group, a sulfonamide group, a sulfonimide group, or a sulfo group, and $L^{A1}$ represents a hydrocarbon group.

In Formula (B), $X^{B1}$ and $X^{B2}$ each independently represent a carboxy group, a mercapto group, an amino group, a hydroxy group, a phospho group, a phosphonate group, a sulfonamide group, a sulfonimide group, or a sulfo group,

$X^{B3}$ represents S, O, or NH, and
$L^{B1}$ and $L^{B2}$ each independently represent a hydrocarbon group.

In Formula (C), $X^{C1}$ to $X^{C3}$ each independently represent a carboxy group, a mercapto group, an amino group, a hydroxy group, a phospho group, a phosphonate group, a sulfonamide group, a sulfonimide group, or a sulfo group,

$X^{C4}$ represents N, and
$L^{C1}$ to $L^{C3}$ each independently represent a hydrocarbon group.

The amino group represented by $X^{A1}$, $X^{A2}$, $X^{B1}$, $X^{B2}$, $X^{C1}$, $X^{C2}$, or $X^{C3}$ is not limited to $-NH_2$ and includes a substituted amino group and a cyclic amino group as well. Examples of the substituted amino group include a monoalkylamino group, a dialkylamino group, a monoarylamino group, a diarylamino group, and an alkylarylamino group. The amino group represented by these groups is preferably $-NH_2$, a monoalkylamino group, or a dialkylamino group, and more preferably $-NH_2$.

The hydrocarbon group represented by $L^{A1}$, $L^{B1}$, $L^{B2}$, $L^{C1}$, $L^{C2}$, or $L^{C3}$ is preferably an aliphatic hydrocarbon group or a group including an aromatic ring and more preferably an aliphatic hydrocarbon group. The aliphatic hydrocarbon group may be a saturated aliphatic hydrocarbon group or may be an unsaturated aliphatic hydrocarbon group. The hydrocarbon group preferably has 1 to 20 carbon atoms. The upper limit of the number of carbon atoms is preferably 10 or less, more preferably 6 or less, and still more preferably 3 or less. Specific examples of the hydrocarbon group include an alkylene group, an alkenylene group, an alkynylene group, and an arylene group.

Examples of the alkylene group include a linear alkylene group, a branched alkylene group, and a cyclic alkylene group. A linear alkylene group or a branched alkylene group is preferable, and a linear alkylene group is more preferable. Examples of the alkenylene group include a linear alkenylene group, a branched alkenylene group, and a cyclic alkenylene group. A linear alkenylene group or a branched alkenylene group is preferable, and a linear alkenylene group is more preferable. Examples of the alkynylene group include a linear alkynylene group and a branched alkynylene group, and a linear alkynylene group is preferable. The arylene group may be monocyclic or may be polycyclic. The monocyclic arylene group is preferable. Specific examples of the arylene group include a phenylene group and a naphthylene group. Among these, a phenylene group is preferable. The alkylene group, the alkenylene group, the alkynylene group, and the arylene group may further have a substituent. The substituent is preferably a group having 1 or more and 10 or less of atoms. Preferred specific examples of the group having 1 or more and 10 or less of atoms include an alkyl group having 1 to 3 carbon atoms [a methyl group, an ethyl group, a propyl group, or an isopropyl group], an alkenyl group having 2 or 3 carbon atoms [an ethenyl group or a propenyl group], an alkynyl group having 2 to 4 carbon atoms [an ethynyl group, a propynyl group, or the like], a cyclopropyl group, an alkoxy group having 1 or 2 carbon atoms [a methoxy group or an ethoxy group], an acyl group having 2 or 3 carbon atoms [an acetyl group or a propionyl group], an alkoxycarbonyl group having 2 or 3 carbon atoms [a methoxycarbonyl group or an ethoxycarbonyl group], an acyloxy group having 2 carbon atoms [an

acetyloxy group], an acylamino group having 2 carbon atoms [an acetylamino group], a hydroxyalkyl group having 1 to 3 carbon atoms [a hydroxymethyl group, a hydroxyethyl group, or a hydroxypropyl group], an aldehyde group, a hydroxy group, a carboxy group, a sulfo group, a phospho group, a carbamoyl group, a cyano group, an isocyanate group, a mercapto group, a nitro group, a nitroxy group, an isothiocyanate group, a cyanate group, a thiocyanate group, an acetoxy group, an acetamide group, a formyl group, a formyloxy group, a formamide group, a sulfamino group, a sulfino group, a sulfamoyl group, a phosphono group, an acetyl group, a halogen atom, and an alkali metal atom.

In Formula (A), $X^{A1}$ and $X^{12}$ are separated by $L^{A1}$ preferably by 1 to 10 atoms, more preferably separated by 1 to 6 atoms, still more preferably separated by 1 to 4 atoms, even still more preferably separated by 1 to 3 atoms, and particularly preferably separated by 1 or 2 atoms.

In Formula (B), $X^{B1}$ and $X^{B3}$ are separated by $L^{B1}$ preferably by 1 to 10 atoms, more preferably separated by 1 to 6 atoms, still more preferably separated by 1 to 4 atoms, even still more preferably separated by 1 to 3 atoms, and particularly preferably separated by 1 or 2 atoms. In addition, $X^{B2}$ and $X^{B3}$ are separated by $L^{B2}$ preferably by 1 to 10 atoms, more preferably separated by 1 to 6 atoms, still more preferably separated by 1 to 4 atoms, even still more preferably separated by 1 to 3 atoms, and particularly preferably separated by 1 or 2 atoms.

In Formula (C), $X^{C1}$ and $X^{C4}$ are separated by $L^{C1}$ preferably by 1 to 10 atoms, more preferably separated by 1 to 6 atoms, still more preferably separated by 1 to 4 atoms, even still more preferably separated by 1 to 3 atoms, and particularly preferably separated by 1 or 2 atoms. In addition, $X^{C2}$ and $X^{C4}$ are separated by $L^{C2}$ preferably by 1 to 10 atoms, more preferably separated by 1 to 6 atoms, still more preferably separated by 1 to 4 atoms, even still more preferably separated by 1 to 3 atoms, and particularly preferably separated by 1 or 2 atoms. In addition, $X^{C3}$ and $X^{C4}$ are separated by $L^{C3}$ preferably by 1 to 10 atoms, more preferably separated by 1 to 6 atoms, still more preferably separated by 1 to 4 atoms, even still more preferably separated by 1 to 3 atoms, and particularly preferably separated by 1 or 2 atoms.

It is noted that the description that $X^{A1}$ and $X^{12}$ are separated by $L^{A1}$ by 1 to 10 atoms means that the number of atoms constituting a molecular chain having the shortest distance, connecting $X^{A1}$ and $X^{A2}$, is 1 to 10 atoms. For example, in a case of Formula (A1), $X^{A1}$ and $X^{12}$ are separated by two atoms, and in cases of Formulae (A2) and (A3), $X^{A1}$ and $X^{A2}$ are separated by 3 atoms. The numbers added to the following structural formulae represent the arrangement order of atoms constituting a molecular chain having the shortest distance, connecting $X^{A1}$ and $X^{A2}$.

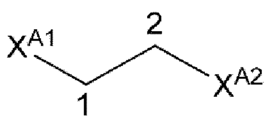
(A1)

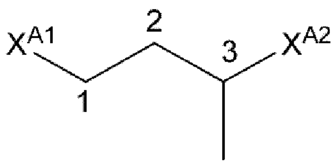
(A2)

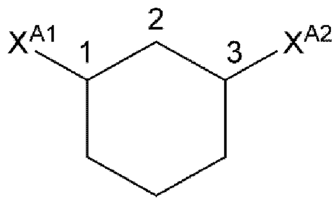
(A3)

To make a description with a specific compound, 3-mercaptopropionic acid is a compound (a compound having the following structure) having a structure in which a moiety corresponding to $X^{A1}$ is a carboxy group, a moiety corresponding to $X^{A2}$ is a mercapto group, and a moiety corresponding to $L^{A1}$ is an ethylene group. In 3-mercaptopropionic acid, $X^{A1}$ (the carboxy group) and $X^{A2}$ (the mercapto group) are separated by $L^{A1}$ (the ethylene group) by two atoms.

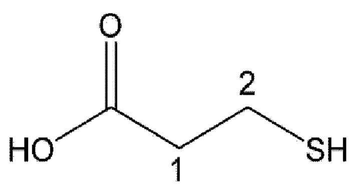

The same applies to the meanings that $X^{B1}$ and $X^{B3}$ are separated by $L^{B1}$ by 1 to 10 atoms, $X^{B2}$ and $X^{B3}$ are separated by $L^{B2}$ by 1 to 10 atoms, $X^{C1}$ and $X^{C4}$ are separated by $L^{C1}$ by 1 to 10 atoms, $X^{C2}$ and $X^{C4}$ are separated by $L^{C2}$ by 1 to 10 atoms, and $X^{C3}$ and $X^{C4}$ are separated by $L^{C3}$ by 1 to 10 atoms.

Specific examples of the multidentate ligand include ethanedithiol, 3-mercaptopropionic acid, thiosalicylic acid, thioglycolic acid, 2-aminoethanol, 2-aminoethanethiol, 2-mercaptoethanol, glycolic acid, ethylenediamine, aminosulfonic acid, glycine, aminomethylphosphoric acid, guanidine, diethylenetriamine, tris(2-aminoethyl)amine, 4-mercaptobutanoic acid, 3-aminopropanol, 3-mercaptopropanol, N-(3-aminopropyl)-1,3-propanediamine, 3-(bis(3-aminopropyl)amino)propan-1-ol,1-thioglycerol, dimercaprol, 1-mercapto-2-butanol, 1-mercapto-2-pentanol, 3-mercapto-1-propanol, 2,3-dimercapto-1-propanol, diethanolamine, 2-(2-aminoethyl)aminoethanol, dimethylenetriamine, 1,1-oxybismethylamine, 1,1-thiobismethylamine, 2-[(2-aminoethyl)amino]ethanethiol, bis(2-mercaptoethyl)amine, 2-aminoethane-1-thiol, 1-amino-2-butanol, 1-amino-2-pentanol, L-cysteine, D-cysteine, 3-amino-1-propanol, L-homoserine, D-homoserine, aminohydroxyacetic acid, L-lactic acid, D-lactic acid, L-malic acid, D-malic acid, glyceric acid, 2-hydroxybutyric acid, L-tartaric acid, D- tartaric acid, tartronic acid, 1,2-benzenedithiol, 1,3-benzenedithiol, 1,4-benzenedithiol, 2-mercaptobenzoic acid, 3-mercaptobenzoic acid, 4-mercaptobenzoic acid, 3-mercapto-2,2-bismercaptomethyl-1-propanol, trimethylolpropane tris(thioglycolate), pentaerythritol tetrakis(mercaptoacetate), dipentaerythritol hexakis(3-mercaptopropionate), dithioerythritol, and derivatives thereof.

For the first ligand, a compound having a boiling point of 200°C or lower is used among the above specific examples. In addition, for the second ligand, a compound having a boiling point of higher than 200°C is used among the above specific examples.

Due to the reason that it is possible to form a quantum dot film that has a higher external quantum efficiency with respect to light having a wavelength in the infrared range and has a smaller dark current, the multidentate organic ligand is preferably ethanedithiol, 3-mercaptopropionic acid, thioglycolic acid, 2-aminoethanol, 2-aminoethanethiol, 2-mercaptoethanol, 2,3-dimercapto-1-propanol, glycolic acid, diethylenetriamine, tris(2-aminoethyl)amine, 1-thioglycerol, dimercaprol, ethylenediamine, ethylene glycol, aminosulfonic acid, glycine, (aminomethyl)phosphonic acid, guanidine, diethanolamine, 2-(2-aminoethyl)aminoethanol, homoserine, cysteine, thiomalic acid, malic acid, 2-mercaptobenzoic acid, tartaric acid, trimethylolpropane tris(thioglycolate), pentaerythritol tetrakis(mercaptoacetate), dipentaerythritol hexakis(3-mercaptopropionate), or dithioerythritol, and more preferably 3-mercaptopropionic acid, 2,3-dimercapto-1-propanol, 2-mercaptobenzoic acid, trimethylolpropane tris(thioglycolate), pentaerythritol tetrakis(mercaptoacetate), dipentaerythritol hexakis(3-mercaptopropionate), or dithioerythritol.

The content of the ligand in the dispersion liquid is preferably 1% to 15% by mass with respect to the total mass of the dispersion liquid. The lower limit thereof is preferably 2% by mass or more and more preferably 2.5% by mass or more. The lower limit thereof is preferably 10% by mass or less and more preferably 7% by mass or less.

In addition, the content of the ligand in the dispersion liquid is preferably 10 to 150 mg/mL. The lower limit thereof is preferably 20 mg/mL or more and more preferably 25 mg/mL or more. The upper limit thereof is preferably 100 mg/mL or less and more preferably 70 mg/mL or less.

In addition, the content of the ligand is preferably 10 to 100 parts by mass with respect to 100 parts by mass of the quantum dot. The lower limit thereof is preferably 20 parts by mass or more and more preferably 30 parts by mass or more. The upper limit thereof is preferably 80 parts by mass or less and more preferably 70 parts by mass or less.

The content of the first ligand (the ligand having a boiling point of 200°C or lower) in the dispersion liquid is preferably 1% to 15% by mass. The lower limit thereof is preferably 1.5% by mass or more. The upper limit thereof is preferably 10% by mass or less and more preferably 5% by mass or less.

In addition, the content of the first ligand (the ligand having a boiling point of 200°C or lower) in the dispersion liquid is preferably 10 to 150 mg/mL. The lower limit thereof is preferably 15 mg/mL or more. The upper limit thereof is preferably 100 mg/mL or less and more preferably 50 mg/mL or less.

In addition, the content of the first ligand (the ligand having a boiling point of 200°C or lower) is preferably 10 to 90 parts by mass with respect to 100 parts by mass of the quantum dot. The lower limit thereof is preferably 15 parts by mass or more. The upper limit thereof is preferably 70 parts by mass or less and more preferably 50 parts by mass or less.

(Solvent)

The dispersion liquid according to the embodiment of the present invention contains a solvent. The solvent is not particularly limited; however, it is preferably a solvent that hardly dissolves the quantum dots and easily dissolves the ligand. The solvent is preferably an organic solvent. The organic solvent may be a protic solvent or may be an aprotic solvent; however, it is preferably an aprotic solvent and more preferably an aprotic polar solvent.

The boiling point of the solvent is preferably 60°C to 250°C. The lower limit thereof is preferably 70°C or higher and more preferably 80°C or higher. The upper limit thereof is preferably 200°C or lower and more preferably 190°C or lower.

Specific examples of the solvent include an alkane [n-hexane, n-octane, or the like], benzene, toluene, N,N-dimethylformamide, dimethyl sulfoxide, N-methylformamide, N,N-dimethylacetamide, propylene carbonate, and ethylene glycol, where the solvent is preferably N,N-dimethylformamide, dimethyl sulfoxide, or N-methylformamide.

The content of the solvent in the dispersion liquid is preferably 50% to 99% by mass, more preferably 70% to 99% by mass, and still more preferably 85% to 98% by mass, with respect to the total mass of the dispersion liquid. The solvent contained in the dispersion liquid may be only one kind or may be a mixed solvent in which two or more kinds are mixed. In a case where the photopolymerizable composition contains two or more kinds of solvents, it is preferable that the total amount thereof is in the above-described ranges.

<Manufacturing method for quantum dot film>

A manufacturing method for a quantum dot film according to an embodiment of the present invention includes a step of applying the above-described dispersion liquid according to the embodiment of the present invention onto a support to form a composition layer and a step of drying the composition layer.

The shape, structure, size, and the like of the support onto which the dispersion liquid is applied are not particularly limited and can be appropriately selected according to the intended purpose. The structure of the support may be a monolayer structure or may be a laminated structure. As the support, for example, a support composed of an inorganic material such as such, glass, or yttria-stabilized zirconia (YSZ), a resin, a resin composite material, or the like can be used. In addition, an electrode, an insulating film, or the like may be formed on the support. In this case, the dispersion liquid is also applied onto the electrode or the insulating film on the support.

A method of applying the dispersion liquid onto the support is not particularly limited. Examples thereof include coating methods such as a spin coating method, a dipping method, an ink jet method, a dispenser method, a screen printing method, a relief printing method, an intaglio printing method, and a spray coating method.

After forming the composition layer, drying is carried out. By carrying out drying, the solvent remaining in the composition layer can be removed. Further, at least a part of low-boiling point ligands such as ligands having a boiling point of 200°C or lower are also removed from the composition layer, and thus the spacing between the quantum dots can be made closer.

Regarding the drying temperature, the drying temperature is preferably 50°C to 150°C. The upper limit of the drying temperature is preferably 120°C or lower and more preferably 100°C or lower. The lower limit of the drying temperature is preferably 55°C or higher and more preferably 60°C or higher. In a case where the drying temperature is within the above-described range, it is possible to manufacture a quantum dot film in which the surface result is small and the spacing between the quantum dots is made close.

The drying time is preferably 1 to 30 minutes. The upper limit of the drying time is preferably 20 minutes or less and more preferably 10 minutes or less. The lower limit of the drying time is preferably 2 minutes or more and more preferably 5 minutes or more. In a case where the drying time is within the above-described range, it is possible to manufacture a quantum dot film in which the surface result is small and the spacing between the quantum dots is made close.

In the manufacturing method for a quantum dot film according to the embodiment of the present invention, the step of forming a composition layer and the step of drying the composition layer may be alternately repeated a plurality of times.

In the manufacturing method for a quantum dot film according to the embodiment of the present invention, a step of applying a ligand solution may be carried out after the step of drying the composition layer. In a case where this step is carried out, the ligand coordinated to the quantum dot can be exchanged with a ligand contained in the ligand solution, or a ligand contained in the ligand solution can be coordinated to the quantum dot to suppress the generation of surface defects of the quantum dot.

Examples of the ligand contained in the ligand solution include the ligands described as those that are used in the dispersion liquid according to the embodiment of the present invention. The ligand contained in the ligand solution may be the same as or different from the ligand contained in the dispersion liquid. The ligand solution may contain only one kind of ligand or may contain two or more kinds thereof. In addition, in the step of applying the ligand solution, two or more kinds of the ligand solutions may be used.

The solvent contained in the ligand solution is preferably selected appropriately according to the kind of the ligand contained in the ligand solution, and it is preferably a solvent that easily dissolves the ligand. In addition, the solvent contained in the ligand solution is preferably an organic solvent having a high dielectric constant. Specific examples thereof include ethanol, acetone, methanol, acetonitrile, dimethylformamide, dimethyl sulfoxide, butanol, and propanol. In addition, the solvent contained in the ligand solution is preferably a solvent that hardly remains in a quantum dot film to be formed. It is preferably an alcohol, ketone, or nitrile which has a low boiling point, and more preferably methanol, ethanol, acetone, or acetonitrile from the viewpoint of easy drying and easy removal by washing.

A method of applying the ligand solution is the same as the method of applying the dispersion liquid onto the support, and the same applies to the preferred aspect thereof.

In a case where the step of applying the ligand solution is carried out, a step (rinsing step) of bringing the film after the application of the ligand solution into contact with a rinsing liquid to rinse the film may be carried out. In a case where the rinsing step is carried out, it is possible to remove the excessive ligand contained in the film and the ligand eliminated from the quantum dots. In addition, it is possible to remove the remaining solvent and other impurities. The rinsing liquid is preferably an aprotic solvent due to the reason that it is easier to effectively remove excess ligands contained in the film and ligands eliminated from the quantum dots, and it is easy to keep the film surface shape uniform by rearranging the surface of the quantum dots. Specific examples of the aprotic solvent include acetonitrile, acetone, methyl ethyl ketone, methyl isobutyl ketone, cyclopentanone, diethyl ether, tetrahydrofuran, cyclopentyl methyl ether, dioxane, ethyl acetate, butyl acetate, propylene glycol monomethyl ether acetate, hexane, octane, cyclohexane, benzene, toluene, chloroform, carbon

tetrachloride, and dimethylformamide, where acetonitrile or tetrahydrofuran is preferable, and acetonitrile is more preferable.

In addition, the rinsing step may be carried out a plurality of times by using two or more kinds of rinsing liquids differing in polarity (relative permittivity). For example, it is preferable that, first, a rinsing liquid (also referred to as a first rinsing liquid) having a high relative permittivity is used to carry out rinsing, and then a rinsing liquid (also referred to as a second rinsing liquid) having a relative permittivity lower than that of the first rinsing liquid is used to carry out rinsing. The relative permittivity of the first rinsing liquid is preferably 15 to 50, more preferably 20 to 45, and still more preferably 25 to 40. The relative permittivity of the second rinsing liquid is preferably 1 to 15, more preferably 1 to 10, and still more preferably 1 to 5.

Through such steps, a quantum dot film can be manufactured. The quantum dot film obtained by the manufacturing method for a quantum dot film according to the embodiment of the present invention can be used for a photodetection element or an image sensor. More specifically, it can be used for a photoelectric conversion layer of a photodetection element or an image sensor.

<Photodetection element and manufacturing method therefor>

The dispersion liquid according to the embodiment of the present invention can be used for a photoelectric conversion element. More preferably, it is used for forming a photoelectric conversion layer of a photoelectric conversion element. In addition, the manufacturing method for a photodetection element according to the embodiment of the present invention includes the above-described manufacturing method for a quantum dot film according to the embodiment of the present invention. Specifically, it is preferable to form the photoelectric conversion layer of the photodetection element by using the above-described manufacturing method for a quantum dot film according to the embodiment of the present invention.

Examples of the type of photodetection element include a photoconductor-type photodetection element and a photodiode-type photodetection element. Among the above, a photodiode-type photodetection element is preferable due to the reason that a high signal-to-noise ratio (SN ratio) is easily obtained.

Since the quantum dot film obtained by using the dispersion liquid according to the embodiment of the present invention has excellent sensitivity to light having a wavelength in the infrared range, the photodetection element in which this quantum dot film is used for the photoelectric conversion layer is preferably used as a photodetection element that detects light having a wavelength in the infrared range. That is, the photodetection element is preferably used as an infrared photodetection element.

The light having a wavelength in the infrared range is preferably light having a wavelength such that the wavelength is more than 700 nm, more preferably light having a wavelength of 800 nm or more, and still more preferably light having a wavelength of 900 nm or more. In addition, the light having a wavelength in the infrared range is preferably light having a wavelength of 2,000 nm or less and more preferably light having a wavelength of 1,600 nm or less.

The photodetection element may be a photodetection element that simultaneously detects light having a wavelength in the infrared range and light having a wavelength in the visible region (preferably light having a wavelength in a range of 400 to 700 nm).

Fig. 1 is a diagram illustrating an embodiment of a photodetection element. Fig. 1 is a view illustrating an embodiment of a photodiode-type photodetection element. It is noted that an arrow in the figure represents the incidence ray on the photodetection element. A photodetection element 1 illustrated in Fig. 1 includes a second electrode layer 12, a first electrode layer 11 provided to be opposite to the second electrode layer 12, a photoelectric conversion layer 13 provided between the second electrode layer 12 and the first electrode layer 11, an electron transport layer 21 provided between the first electrode layer 11 and the photoelectric conversion layer 13, and a hole transport layer 22 provided between the second electrode layer 12 and the photoelectric conversion layer 13. The photodetection element 1 illustrated in Fig. 1 is used by causing light to be incident from above the first electrode layer 11. Although not illustrated in the drawing, a transparent substrate may be disposed on the surface of the first electrode layer 11 on the light incident side. Examples of the kind of transparent substrate include a glass substrate, a resin substrate, and a ceramic substrate.

(First electrode layer)

The first electrode layer 11 is preferably a transparent electrode formed of a conductive material that is substantially transparent with respect to the wavelength of the target light to be detected by the photodetection element. It is noted that in the present specification, the description of "substantially transparent" means that the light transmittance is 50% or more, preferably 60% or more, and particularly preferably 80% or more. Examples of the material of the first electrode layer 11 include a conductive metal oxide. Specific examples thereof include tin oxide, zinc oxide, indium oxide, indium tungsten oxide, indium zinc oxide (IZO), indium tin oxide (ITO), and a fluorine-doped tin oxide (FTO).

The film thickness of the first electrode layer 11 is not particularly limited, and it is preferably 0.01 to 100 μm, more

preferably 0.01 to 10 μm, and particularly preferably 0.01 to 1 μm. The film thickness of each layer can be measured by observing the cross section of the photodetection element 1 using a scanning electron microscope (SEM) or the like.

(Electron transport layer)

The electron transport layer 21 is a layer having a function of transporting electrons generated in the photoelectric conversion layer 13 to the electrode layer. The electron transport layer is also called a hole block layer. The electron transport layer is formed of an electron transport material that is capable of exhibiting this function.

Examples of the electron transport material include a fullerene compound such as [6,6]-phenyl-C61-butyric acid methyl ester ($PC_{61}BM$), a perylene compound such as perylenetetracarboxylic diimide, tetracyanoquinodimethane, titanium oxide, tin oxide, zinc oxide, indium oxide, indium tungsten oxide, indium zinc oxide, indium tin oxide, and fluorine-doped tin oxide. The electron transport material may be a particle.

In addition, it is also preferable that the electron transport layer is composed of a layer containing zinc oxide doped with a metal atom other than Zn. Hereinafter, the zinc oxide doped with a metal atom other than Zn is also referred to as the doped zinc oxide.

The metal atom other than Zn in the doped zinc oxide is preferably a monovalent to trivalent metal atom, more preferably a metal atom including at least one selected from Li, Mg, Al, or Ga, still more preferably Li, Mg, Al, or Ga, and particularly preferably Li or Mg.

In the doped zinc oxide, the proportion of the metal atom other than Zn to the total of Zn and the metal atom other than Zn is preferably 1% by atom or more, more preferably 2% by atom or more, and still more preferably 4% by atom or more. From the viewpoint of suppressing an increase in crystal defects, the upper limit thereof is preferably 20% by atom or less, more preferably 15% by atom or less, and still more preferably 12% by atom or less. It is noted that the proportion of the metal atom other than Zn in the doped zinc oxide can be measured according to a high-frequency inductively coupled plasma (ICP) method.

From the viewpoint of reducing the organic residual component and increasing the area for contact with the photoelectric conversion layer, the doped zinc oxide is preferably a particle (a doped zinc oxide particle). In addition, the average particle diameter of the doped zinc oxide particles is preferably 2 to 30 nm. The lower limit value of the average particle diameter of the doped zinc oxide particles is preferably 3 nm or more and more preferably 5 nm or more. In addition, the upper limit value of the average particle diameter of the doped zinc oxide particles is preferably 20 nm or less and more preferably 15 nm or less. In a case where the average particle diameter of the doped zinc oxide particles is within the above-described range, it is easy to obtain a film that has a large area for contact with the photoelectric conversion layer and has a high flatness. It is noted that in the present specification, the value of the average particle diameter of the doped zinc oxide particles is an average value of the particle diameters of ten quantum dots which are randomly selected. A transmission electron microscope may be used to measure the particle diameter of the doped zinc oxide particles.

The electron transport layer may be a single-layer film or a laminated film having two or more layers. The thickness of the electron transport layer is preferably 10 to 1,000 nm. The upper limit thereof is preferably 800 nm or less. The lower limit thereof is preferably 20 nm or more and more preferably 50 nm or more. In addition, the thickness of the electron transport layer is preferably 0.05 to 10 times, more preferably 0.1 to 5 times, and still more preferably 0.2 to 2 times the thickness of the photoelectric conversion layer 13.

The electron transport layer may be subjected to an ultraviolet ozone treatment. In particular, in a case of a layer consisting of nanoparticles as the electron transport layer, it is desirable to carry out an ultraviolet ozone treatment. In a case where the ultraviolet ozone treatment is carried out, it is possible to improve the wettability of the quantum dot dispersion liquid on the electron transport layer can be improved and decompose or remove the residual organic substances in the electron transport layer, which makes it possible to obtain high element performance. The wavelength of the ultraviolet rays for irradiation can be selected in a wavelength range of 100 to 400 nm. In particular, due to the reason that the above-described effect is easily obtained and excessive damage to a film can be avoided, it is preferable that the peak intensity is present in a wavelength range of 200 to 300 nm, and it is more preferable that the peak intensity is present in a wavelength range of 240 to 270 nm. The irradiation intensity of the ultraviolet rays is not particularly limited; however, it is preferably 1 to 100 $mW/cm^2$ and more preferably 10 to 50 $mW/cm^2$ due to the reason that the above-described effect is easily obtained and excessive damage to a film can be avoided. The treatment time is not particularly limited; however, it is preferably 1 to 60 minutes, more preferably 1 to 20 minutes, and still more preferably 3 to 15 minutes, for the same reason as described above.

(Photoelectric conversion layer)

The photoelectric conversion layer 13 is composed of a quantum dot film formed by using the above-described dispersion liquid according to the embodiment of the present invention. The photoelectric conversion layer 13 can be manufactured by the above-described manufacturing method for a quantum dot film according to the embodiment of the

present invention.

The thickness of the photoelectric conversion layer 13 is preferably 10 to 1,000 nm. The lower limit of the thickness is preferably 20 nm or more and more preferably 30 nm or more. The upper limit of the thickness is preferably 600 nm or less, more preferably 550 nm or less, still more preferably 500 nm or less, and particularly preferably 450 nm or less. The refractive index of the photoelectric conversion layer 13 with respect to light having a target wavelength to be detected by the photodetection element can be set to 1.5 to 5.0.

(Hole transport layer)

The hole transport layer 22 is a layer having a function of transporting holes generated in the photoelectric conversion layer 13 to the electrode layer. The hole transport layer is also called an electron block layer.

The hole transport layer 22 is formed of a hole transport material capable of exhibiting this function. Examples of the hole transport material include PEDOT:PSS (poly(3,4-ethylenedioxythiophene):poly(4-styrenesulfonic acid)), PTB7 (poly{4,8-bis[(2-ethylhexyl)oxy]benzo[1,2-b:4,5-b']dithiophen-2,6-diyl-lt-alt-3-fluoro-2-[(2-et hylhexyl)carbonyl]thieno [3,4-b]thiophen-4,6-diyl}), PTB7-Th (poly([2,6'-4,8-di(5-ethylhexylthienyl)benzo[1,2-b:3,3-b']dithiophen]{3-fluoro-2-[(2-ethylhex yl)l)carbonyl]thieno[3,4-b]thiophendiyl})), PC71BM ([6,6]-phenyl-C71-methyl butyrate), and MoOs. In addition, the organic hole transport material disclosed in paragraph Nos. 0209 to 0212 of JP2001-291534A can also be used. In addition, a quantum dot can also be used in the hole transport material. Examples of the quantum dot material that constitutes the quantum dot include a nanoparticle (a particle having a size of 0.5 nm or more and less than 100 nm) of a general semiconductor crystal [a) a Group IV semiconductor, b) a compound semiconductor of a Group IV to IV element, a Group III to V element, or a Group II to VI element, or c) a compound semiconductor consisting of a combination of three or more of a Group II element, a Group III element, a Group IV element, a Group V element, and a Group VI element]. Specific examples thereof include semiconductor materials having a relatively narrow band gap, such as PbS, PbSe, PbSeS, InN, Ge, InAs, InGaAs, CuInS, CuInSe, CuInGaSe, InSb, HgTe, HgCdTe, $Ag_2S$, $Ag_2Se$, $Ag_2Te$, SnS, SnSe, SnTe, Si, and InP. A ligand may be coordinated on the surface of the quantum dot.

The thickness of the hole transport layer 22 is preferably 5 to 100 nm. The lower limit thereof is preferably 10 nm or more. The upper limit thereof is preferably 50 nm or less and more preferably 30 nm or less.

(Second electrode layer)

The second electrode layer 12 is preferably composed of a metal material containing at least one metal atom selected from Ag, Au, Pt, Ir, Pd, Cu, Pb, Sn, Zn, Ti, W, Mo, Ta, Ge, Ni, Al, Cr, or In. Since the second electrode layer 12 is composed of such a metal material, it is possible for the photodetection element to have a high external quantum efficiency and a low dark current. In addition, the above-described conductive metal oxide, a carbon material, a conductive polymer, and the like can also be used for the second electrode layer 12. The carbon material may be any material having conductivity, and examples thereof include fullerene, a carbon nanotube, graphite, and graphene.

The work function of the second electrode layer 12 is preferably 4.6 eV or more, more preferably 4.8 to 5.7 eV, and still more preferably 4.9 to 5.3 eV, due to the reason that the electron blocking property due to the hole transport layer is increased and the holes generated in the element are easily collected.

The film thickness of the second electrode layer 12 is not particularly limited, and it is preferably 0.01 to 100 μm, more preferably 0.01 to 10 μm, and particularly preferably 0.01 to 1 μm.

(Blocking layer)

Although not illustrated in the drawing, the photodetection element may have a blocking layer between the first electrode layer 11 and the electron transport layer 21. The blocking layer is a layer having a function of preventing a reverse current. The blocking layer is also called a short circuit prevention layer. Examples of the material that forms the blocking layer include silicon oxide, magnesium oxide, aluminum oxide, calcium carbonate, cesium carbonate, polyvinyl alcohol, polyurethane, titanium oxide, tin oxide, zinc oxide, niobium oxide, and tungsten oxide. The blocking layer may be a single-layer film or a laminated film having two or more layers.

In the photodetection element, a wavelength $\lambda$ of the target light to be detected by the photodetection element and an optical path length $L^{\lambda}$ of the light having the wavelength $\lambda$ from the surface of the second electrode layer 12 on the side of the photoelectric conversion layer 13 to the surface of the photoelectric conversion layer 13 on the side of the first electrode layer 11 preferably satisfy the relationship of Formula (1-1), and more preferably satisfy the relationship of Formula (1-2). In a case where the wavelength $\lambda$ and the optical path length $L^{\lambda}$ satisfy such a relationship, in the photoelectric conversion layer 13, it is possible to arrange phases of the light (the incidence ray) incident from the side of the first electrode layer 11 and phases of the light (the reflected light) reflected on the surface of the second electrode layer 12, and as a result, the light is intensified by the optical interference effect, whereby it is possible to obtain a higher external quantum efficiency.

$$0.05 + m/2 \leq L^{\lambda}/\lambda \leq 0.35 + m/2 \quad \cdots(1\text{-}1)$$

$$0.10 + m/2 \leq L^{\lambda}/\lambda \leq 0.30 + m/2 \quad \cdots(1\text{-}2)$$

In the above expressions, $\lambda$ is the wavelength of the target light to be detected by the photodetection element,

$L^{\lambda}$ is the optical path length of the light having the wavelength $\lambda$ from a surface of the second electrode layer 12 on a side of the photoelectric conversion layer 13 to a surface of the photoelectric conversion layer 13 on a side of the first electrode layer 11, and
m is an integer of 0 or more.

m is preferably an integer of 0 to 4, more preferably an integer of 0 to 3, and still more preferably an integer of 0 to 2. According to this aspect, the transport characteristics of charges such as the hole and the electron are good, and thus it is possible to increase the external quantum efficiency of the photodetection element.
Here, the optical path length means the product obtained by multiplying the physical thickness of a substance through which light transmits by the refractive index. To make a description with the photoelectric conversion layer 13 as an example, in a case where the thickness of the photoelectric conversion layer is denoted by $d^1$ and the refractive index of the photoelectric conversion layer with respect to light having a wavelength $\lambda^1$ is denoted by $N^1$, the optical path length of the light having the wavelength $\lambda^1$ and transmitting through the photoelectric conversion layer 13 is $N^1 \times d^1$. In a case where the photoelectric conversion layer 13 or the hole transport layer 22 is composed of two or more laminated films or in a case where an interlayer is present between the hole transport layer 22 and the second electrode layer 12, the integrated value of the optical path length of each layer is the optical path length $L^{\lambda}$.

<Image sensor and manufacturing method therefor>

The dispersion liquid according to the embodiment of the present invention can be used for a photoelectric conversion element. It is more preferably used for forming a photoelectric conversion layer of an image sensor. In addition, the manufacturing method for an image sensor according to the embodiment of the present invention includes the above-described manufacturing method for a quantum dot film according to the embodiment of the present invention. Specifically, it is preferable to form the photoelectric conversion layer of the image sensor by using the above-described manufacturing method for a quantum dot film according to the embodiment of the present invention.
Since the quantum dot film obtained by using the dispersion liquid according to the embodiment of the present invention has excellent sensitivity to light having a wavelength in the infrared range, an image sensor in which this quantum dot film is used for a photoelectric conversion layer can be particularly preferably used as an infrared sensor. In addition, the above-described image sensor can be preferably used as a sensor that senses light having a wavelength of 900 to 2,000 nm and can be more preferably used as a sensor that senses light having a wavelength of 900 to 1,600 nm.
The configuration of the image sensor is not particularly limited as long as it has the photodetection element and it is a configuration that functions as an image sensor. Examples of the photodetection element include the above-described photodetection element.
The image sensor invention may include an infrared transmitting filter layer. The infrared transmitting filter layer preferably has a low light transmittance in the wavelength range of the visible region, more preferably has an average light transmittance of 10% or less, still more preferably 7.5% or less, and particularly preferably 5% or less in a wavelength range of 400 to 650 nm.
Examples of the infrared transmitting filter layer include those composed of a resin film containing a coloring material. Examples of the coloring material include a chromatic coloring material such as a red coloring material, a green coloring material, a blue coloring material, a yellow coloring material, a purple coloring material, and an orange coloring material, and a black coloring material. It is preferable that the coloring material contained in the infrared transmitting filter layer forms a black color with a combination of two or more kinds of chromatic coloring materials or is a coloring material containing a black coloring material. Examples of the combination of the chromatic coloring material in a case of forming a black color by a combination of two or more kinds of chromatic coloring materials include the following aspects (C1) to (C7).

(C1) an aspect containing a red coloring material and a blue coloring material.
(C2) an aspect containing a red coloring material, a blue coloring material, and a yellow coloring material.
(C3) an aspect containing a red coloring material, a blue coloring material, a yellow coloring material, and a purple coloring material.
(C4) an aspect containing a red coloring material, a blue coloring material, a yellow coloring material, a purple coloring material, and a green coloring material.

(C5) an aspect containing a red coloring material, a blue coloring material, a yellow coloring material, and a green coloring material.
(C6) an aspect containing a red coloring material, a blue coloring material, and a green coloring material.
(C7) an aspect containing a yellow coloring material and a purple coloring material.

The chromatic coloring material may be a pigment or a dye. It may contain a pigment and a dye. The black coloring material is preferably an organic black coloring material. Examples of the organic black coloring material include a bisbenzofuranone compound, an azomethine compound, a perylene compound, and an azo compound.
The infrared transmitting filter layer may further contain an infrared absorber. In a case where the infrared absorber is contained in the infrared transmitting filter layer, the wavelength of the light to be transmitted can be shifted to the longer wave side. Examples of the infrared absorber include a pyrrolo pyrrole compound, a cyanine compound, a squarylium compound, a phthalocyanine compound, a naphthalocyanine compound, a quaterrylene compound, a merocyanine compound, a croconium compound, an oxonol compound, an iminium compound, a dithiol compound, a triarylmethane compound, a pyrromethene compound, an azomethine compound, an anthraquinone compound, a dibenzofuranone compound, a dithiolene metal complex, a metal oxide, and a metal boride.
The spectral characteristics of the infrared transmitting filter layer can be appropriately selected according to the use application of the image sensor. Examples of the filter layer include those that satisfy any one of the following spectral characteristics of (1) to (5).

(1): A filter layer in which the maximum value of the light transmittance in the film thickness direction in a wavelength range of 400 to 750 nm is 20% or less (preferably 15% or less and more preferably 10% or less), and the minimum value of the light transmittance in the film thickness direction in a wavelength range of 900 to 1,500 nm is 70% or more (preferably 75% or more and more preferably 80% or more).
(2): A filter layer in which the maximum value of the light transmittance in the film thickness direction in a wavelength range of 400 to 830 nm is 20% or less (preferably 15% or less and more preferably 10% or less), and the minimum value of the light transmittance in the film thickness direction in a wavelength range of 1,000 to 1,500 nm is 70% or more (preferably 75% or more and more preferably 80% or more).
(3): A filter layer in which the maximum value of the light transmittance in the film thickness direction in a wavelength range of 400 to 950 nm is 20% or less (preferably 15% or less and more preferably 10% or less), and the minimum value of the light transmittance in the film thickness direction in a wavelength range of 1,100 to 1,500 nm is 70% or more (preferably 75% or more and more preferably 80% or more).
(4): A filter layer in which the maximum value of the light transmittance in the film thickness direction in a wavelength range of 400 to 1,100 nm is 20% or less (preferably 15% or less and more preferably 10% or less), and the minimum value thereof in a wavelength range of 1,400 to 1,500 nm is 70% or more (preferably 75% or more and more preferably 80% or more).
(5): A filter layer in which the maximum value of the light transmittance in the film thickness direction in a wavelength range of 400 to 1,300 nm is 20% or less (preferably 15% or less and more preferably 10% or less), and the minimum value thereof in a wavelength range of 1,600 to 2,000 nm is 70% or more (preferably 75% or more and more preferably 80% or more).

Further, as the infrared transmitting filter, the films disclosed in JP2013-077009A, JP2014-130173A, JP2014-130338A, WO2015/166779A, WO2016/178346A, WO2016/190162A, WO2018/016232A, JP2016-177079A, JP2014-130332A, and WO2016/027798A can be used. As the infrared transmitting filter, two or more filters may be used in combination, or a dual bandpass filter that transmits through two or more specific wavelength ranges with one filter may be used.
The image sensor may include an infrared shielding filter for the intended purpose of improving various performances such as noise reduction. Specific examples of the infrared shielding filter include the filters disclosed in WO2016/186050A, WO2016/035695A, JP6248945B, WO2019/021767A, JP2017-067963A, and JP6506529B.
The image sensor may include a dielectric multi-layer film. Examples of the dielectric multi-layer film include those in which a plurality of layers are laminated by alternately laminating a dielectric thin film having a high refractive index (a high refractive index material layer) and a dielectric thin film having a low refractive index (a low refractive index material layer). The number of laminated layers of the dielectric thin film in the dielectric multi-layer film is not particularly limited; however, it is preferably 2 to 100 layers, more preferably 4 to 60 layers, and still more preferably 6 to 40 layers. The material that is used for forming the high refractive index material layer is preferably a material having a refractive index of 1.7 to 2.5. Specific examples thereof include $Sb_2O_3$, $Sb_2S_3$, $Bi_2O_3$, $CeO_2$, $CeF_3$, $HfO_2$, $La_2O_3$, $Nd_2O_3$, $Pr_6O_{11}$, $Sc_2O_3$, SiO, $Ta_2O_5$, $TiO_2$, TlCl, $Y_2O_3$, ZnSe, ZnS, and $ZrO_2$. The material that is used for forming the low refractive index material layer is preferably a material having a refractive index of 1.2 to 1.6. Specific examples thereof include $Al_2O_3$, $BiF_3$, $CaF_2$, $LaF_3$, $PbCl_2$, $PbF_2$, LiF, $MgF_2$, MgO, $NdF_3$, $SiO_2$, $Si_2O_3$, NaF, $ThO_2$, $ThF_4$, and $Na_3AlF_6$. The method for forming the dielectric multi-layer film is not particularly limited; however, examples thereof include ion plating, a vacuum deposition method

using an ion beam or the like, a physical vapor deposition method (a PVD method) such as sputtering, and a chemical vapor deposition method (a CVD method). The thickness of each of the high refractive index material layer and the low refractive index material layer is preferably 0.1 $\lambda$ to 0.5 $\lambda$ in a case where the wavelength of the light to be blocked is $\lambda$ (nm). Specific examples of the usable dielectric multi-layer film include the films disclosed in JP2014-130344A and JP2018-010296A.

In the dielectric multi-layer film, the transmission wavelength range is preferably present in the infrared range (preferably a wavelength range having a wavelength of more than 700 nm, more preferably a wavelength range having a wavelength of more than 800 nm, and still more preferably a wavelength range having a wavelength of more than 900 nm). The maximum transmittance in the transmission wavelength range is preferably 70% or more, more preferably 80% or more, and still more preferably 90% or more. In addition, the maximum transmittance in the shielding wavelength range is preferably 20% or less, more preferably 10% or less, and still more preferably 5% or less. In addition, the average transmittance in the transmission wavelength range is preferably 60% or more, more preferably 70% or more, and still more preferably 80% or more. In addition, in a case where the wavelength at which the maximum transmittance is exhibited is denoted by a central wavelength $\lambda_{t1}$, the wavelength range of the transmission wavelength range is preferably "the central wavelength $\lambda_{t1} \pm 100$ nm", more preferably "the central wavelength $\lambda_{t1} \pm 75$ nm", and still more preferably "the central wavelength $\lambda_{t1} \pm 50$ nm".

The dielectric multi-layer film may have only one transmission wavelength range (preferably, a transmission wavelength range having a maximum transmittance of 90% or more) or may have a plurality of transmission wavelength ranges.

The image sensor may include a color separation filter layer. Examples of the color separation filter layer include a filter layer including colored pixels. Examples of the kind of colored pixel include a red pixel, a green pixel, a blue pixel, a yellow pixel, a cyan pixel, and a magenta pixel. The color separation filter layer may include colored pixels having two or more colors or having only one color. It can be appropriately selected according to the use application and the intended purpose. For example, the filter disclosed in WO2019/039172A can be used.

In addition, in a case where the color separation layer includes colored pixels having two or more colors, the colored pixels of the respective colors may be adjacent to each other, or a partition wall may be provided between the respective colored pixels. The material of the partition wall is not particularly limited. Examples thereof include an organic material such as a siloxane resin or a fluororesin, and an inorganic particle such as a silica particle. In addition, the partition wall may be composed of a metal such as tungsten or aluminum.

It is noted that in a case where the image sensor includes an infrared transmitting filter layer and a color separation layer, it is preferable that the color separation layer is provided on an optical path different from the infrared transmitting filter layer. In addition, it is also preferable that the infrared transmitting filter layer and the color separation layer are disposed two-dimensionally. It is noted that the description that the infrared transmitting filter layer and the color separation layer are disposed two-dimensionally means that at least parts of both are present on the same plane.

The image sensor may include an interlayer such as a planarizing layer, an underlying layer, or an intimate attachment layer, an anti-reflection film, and a lens. As the anti-reflection film, for example, a film produced from the composition disclosed in WO2019/017280A can be used. As the lens, for example, the structure disclosed in WO2018/092600A can be used.

## Examples

Hereinafter, the present invention will be described in detail with reference to Examples. Materials, amounts used, proportions, treatment details, treatment procedures, and the like shown in the following examples can be appropriately changed without departing from the gist of the present invention. Accordingly, a scope of the present invention is not limited to the following specific examples.

[Manufacturing of quantum dot dispersion liquid] (Dispersion liquids 1 to 32)

1 mL of an octane dispersion liquid of quantum dots (concentration of quantum dots: 50 mg/mL, concentration of oleic acid: 50 mg/mL) having a surface to which oleic acid was coordinated, the quantum dots being described in the table below, 0.5 g of a ligand 2 described in the table below, and 5 mL of the solvent described in the table below were measured and put in a centrifugal separation tube, and the resultant mixture was vigorously stirred for 10 minutes. Next, 30 mL of octane was added thereto, followed by vigorous stirring for 1 minute. Then, the operation of removing the upper layer as the octane layer was repeated twice. Then, an excessive amount of toluene was added thereto, followed by centrifugal separation at 4,000 rpm for 5 minutes. 0.5 mL of a mixed liquid of a ligand 1 shown in the table below and a solvent shown in the table below (concentration of ligand 1: 20 mg/mL) was added to the obtained precipitate, and the resultant mixture was stirred for 2 hours to obtain each of ligand-exchanged quantum dot dispersion liquid (dispersion liquids 1 to 32). It is noted that all of the above-described operations were carried out under nitrogen.

The obtained quantum dot dispersion liquid was allowed to stand at 25°C under nitrogen for 1 week or 1 month, and then the presence or absence of aggregates was visually checked to evaluate the dispersibility.

A: Aggregation was not confirmed even after being allowed to stand for 1 month.
B: Although there was slight aggregation after being allowed to stand for 1 month, no aggregation was confirmed after being allowed to stand for 1 week.

[Table 1]

| | Quantum dot | | | Ligand 1 | | Ligand 2 | | Solvent | Dispersibility |
|---|---|---|---|---|---|---|---|---|---|
| | Chemical species | Maximal absorption in terms of absorbance [nm] | Band gap [eV] i | Kind | Boiling point | Kind | Boiling point | | |
| Dispersion liquid 1 | PbS | 936 | 1.32 | Propionic acid | 141°C | 3-mercaptopropionic acid | 244°C | DMF | B |
| Dispersion liquid 2 | PbS | 936 | 1.32 | Ethoxyethylamine | 105°C | 2,3-dimercapto-1 -propanol | 246°C | DMF | A |
| Dispersion liquid 3 | PbS | 936 | 1.32 | N-butyl dimethylamine | 93°C | 2,3-dimercapto-1 -propanol | 246°C | DMF | B |
| Dispersion liquid 4 | PbS | 936 | 1.32 | Ethanedithiol | 146°C | 3-mercaptopropionic acid | 244°C | DMF | B |
| Dispersion liquid 5 | PbS | 936 | 1.32 | Ethanolamine | 170°C | 2,3-dimercapto-1-propanol | 246°C | DMF | B |
| Dispersion liquid 6 | PbS | 936 | 1.32 | Ethyl thioglycolate | 157°C | 3-mercaptopropionic acid | 244°C | DMF | A |
| Dispersion liquid 7 | PbS | 936 | 1.32 | Butyl thioglycolate | 194°C | 3-mercaptopropionic acid | 244°C | DMF | A |
| Dispersion liquid 8 | PbS | 936 | 1.32 | Butyl thioglycolate | 194°C | Ethyl thioglycolate | 157°C | DMF | A |
| Dispersion liquid 9 | PbS | 936 | 1.32 | Ethyl thioglycolate | 157°C | Thiosalicylic acid | 299°C | DMF | A |
| Dispersion liquid 10 | PbS | 936 | 1.32 | Ethyl thioglycolate | 157°C | 2,3-dimercapto-1 -propanol | 246°C | DMF | A |
| Dispersion liquid 11 | PbS | 936 | 1.32 | Ethyl thioglycolate | 157°C | 3-mercapto-2,2-bismercaptomethyl-1-propanol | 367°C | DMF | A |
| Dispersion liquid 12 | PbS | 936 | 1.32 | Ethyl thioglycolate | 157°C | Cysteine | 293°C | DMF | A |
| Dispersion liquid 13 | PbS | 936 | 1.32 | Ethyl thioglycolate | 157°C | 1,3-diamino-2-propanol | 264°C | DMF | A |
| Dispersion liquid 14 | PbS | 936 | 1.32 | Ethyl thioglycolate | 157°C | Phenyl phosphonate | 354°C | DMF | A |

(continued)

| | Quantum dot | | | Ligand 1 | | Ligand 2 | | Solvent | Dispersibility |
|---|---|---|---|---|---|---|---|---|---|
| | Chemical species | Maximal absorption in terms of absorbance [nm] | Band gap [eV] i | Kind | Boiling point | Kind | Boiling point | | |
| Dispersion liquid 15 | PbS | 936 | 1.32 | Ethyl thioglycolate | 157°C | Methanesulfonic acid | 360°C | DMF | A |
| Dispersion liquid 16 | PbS | 936 | 1.32 | Ethyl thioglycolate | 157°C | Trifluoromethanesulfonamide | 165°C | DMF | A |
| Dispersion liquid 17 | PbS | 936 | 1.32 | Ethyl thioglycolate | 157°C | Dibenzenesulfonylimide | 270°C or higher | DMF | A |
| Dispersion liquid 18 | PbS | 936 | 1.32 | Ethyl thioglycolate | 157°C | Trimethylolpropane tris(thioglycolate) | 475°C | DMF | A |
| Dispersion liquid 19 | PbS | 936 | 1.32 | Ethyl thioglycolate | 157°C | Pentaerythritol tetrakis(mercaptoacetate) | 482°C | DMF | A |
| Dispersion liquid 20 | PbS | 936 | 1.32 | Ethyl thioglycolate | 157°C | Dipentaerythritol hexakis(3-mercaptopropionate) | 828°C | DMF | A |
| Dispersion liquid 21 | PbS | 936 | 1.32 | Ethyl thioglycolate | 157°C | Dithioerythritol | 364°C | DMF | A |
| Dispersion liquid 22 | PbS | 936 | 1.32 | Ethyl thioglycolate | 157°C | zinc (II) iodide | 625°C | DMF | A |
| Dispersion liquid 23 | PbS | 936 | 1.32 | Ethyl thioglycolate | 157°C | Lead (II) bromide | 916°C | DMF | A |
| Dispersion liquid 24 | PbS | 936 | 1.32 | Ethyl thioglycolate | 157°C | 3-mercaptopropionic acid | 246°C | DMSO | A |
| Dispersion liquid 25 | PbS | 936 | 1.32 | Ethyl thioglycolate | 157°C | 3-mercaptopropionic acid | 246°C | NMF | A |
| Dispersion liquid 26 | InAs | 939 | 1.32 | Ethyl thioglycolate | 157°C | 3-mercaptopropionic acid | 246°C | DMF | A |
| Dispersion liquid 27 | InAs | 939 | 1.32 | Ethyl thioglycolate | 157°C | Indium (III) bromide | 436°C or higher | DMF | A |

(continued)

| | Quantum dot | | | Ligand 1 | | Ligand 2 | | Solvent | Dispersibility |
|---|---|---|---|---|---|---|---|---|---|
| | Chemical species | Maximal absorption in terms of absorbance [nm] | Band gap [eV] i | Kind | Boiling point | Kind | Boiling point | | |
| Dispersion liquid 28 | PbS | 1215 | 1.02 | Ethyl thioglycolate | 157°C | 3-mercaptopropionic acid | 246°C | DMF | A |
| Dispersion liquid 29 | PbS | 1441 | 0.86 | Ethyl thioglycolate | 157°C | 3-mercaptopropionic acid | 246°C | DMF | A |
| Dispersion liquid 30 | PbS | 1550 | 0.8 | Ethyl thioglycolate | 157°C | 3-mercaptopropionic acid | 246°C | DMF | A |
| Dispersion liquid 31 | $AgBiS_2$ | - | 1.34 | Ethyl thioglycolate | 157°C | 3-mercaptopropionic acid | 246°C | DMF | A |
| Dispersion liquid 32 | AgBiSTe | - | 0.82 | Ethyl thioglycolate | 157°C | 3-mercaptopropionic acid | 246°C | DMF | A |

Details of the materials indicated by abbreviations in the above tables are as follows.

DMF: N,N-dimethylformamide
DMSO: Dimethyl sulfoxide
NMF: N-methylformamide

The boiling points of the ligand 1 and the ligand 2 in the table are values at 1 atm. It is noted that regarding a solid compound having a melting point of 200°C or higher, a value equal to or higher than the melting point temperature or a value of the boiling point is described in the column of the boiling point. In addition, regarding a solid compound having a melting point lower than 200°C, a value predicted by SciFinder is described in the column of boiling point.
As shown in the table above, all of the dispersion liquids 1 to 32 had excellent dispersibility.

[Manufacturing of zinc oxide particle dispersion liquid]

(Zinc oxide particle dispersion liquid 1)

1.5 mmol of zinc acetate dihydrate and 15 ml of dimethyl sulfoxide (DMSO) were measured and put in a flask, and the resultant mixture was stirred to obtain a zinc acetate solution.
A TMAC1 solution obtained by dissolving 4 mmol of tetramethylammonium chloride (TMACl) in 4 ml of methanol and a KOH solution obtained by dissolving 4 mmol of potassium hydroxide (KOH) in 4 ml of methanol were produced. The KOH solution was slowly added while vigorously stirring the TMAC1 solution, and after stirring for 30 minutes, insoluble components were removed through a filter having a pore diameter of 0.45 μm to obtain a tetramethylammonium hydroxide (TMAH) solution.
6 ml of the TMHA solution was added to the zinc acetate solution contained in the flask at a dropwise addition rate of 6 ml/min. After being held for 1 hour, the reaction solution was recovered. An excessive amount of acetone was added to the reaction solution, centrifugal separation was carried out at 10,000 rpm for 10 minutes, and then the supernatant was removed. After dispersing the precipitate in methanol, the precipitate was precipitated again with acetone, 5 ml of ethanol and 80 μl of aminoethanol were added thereto, and ultrasonic dispersion was carried out to obtain a zinc oxide particle dispersion liquid 1 in which the concentration of the non-doped zinc oxide particles was about 30 mg/mL.

[Manufacturing of photodetection element]

(Example 1)

An indium tin oxide (ITO) film having a thickness of about 100 nm was formed on a quartz glass by a sputtering method to form a first electrode layer. Next, a titanium oxide film having a thickness of about 20 nm was formed on the ITO film (first electrode layer) by a sputtering method to form an electron transport layer. Next, the dispersion liquid 2 was added dropwise onto the titanium oxide film (electron transport layer) in a glove box, and then spin coating was carried out at 1,000 rpm, followed by drying at 60°C for 10 minutes to form a quantum dot film. The step of forming the quantum dot film was repeated 6 times to form a photoelectric conversion layer having a thickness of 220 nm. Next, the photoelectric conversion film was dried in a glove box for 10 hours.
Next, a dichlorobenzene solution of PTB7 (poly({4,8-bis[(2-ethylhexyl)oxy]benzo[1,2-b:4,5-b']dithiophen-2,6-diyl}{3-fluoro-2-[(2-ethyl hexyl)carbonyl]thieno[3,4-b]thiophendiyl})) (concentration: 5 mg/mL) was applied onto the photoelectric conversion film by spin coating at 2,000 rpm, and then drying was carried out in a glove box for 10 hours to form a hole transport layer.
Next, a MoOs film having a thickness of 5 nm was formed on the hole transport layer by a vacuum deposition method through a metal mask, and then an Au film (the second electrode layer) having a thickness of 100 nm was formed to manufacture a photodiode-type photodetection element.

(Example 2)

A photodetection element of Example 2 was manufactured in the same method as in Example 1, except that in the step of forming the photoelectric conversion film, the dispersion liquid 6 was used instead of the dispersion liquid 2.

(Example 3)

A photodetection element of Example 3 was manufactured in the same method as in Example 1, except that in the step of forming the photoelectric conversion film, the dispersion liquid 7 was used instead of the dispersion liquid 2.

(Example 4)

A photodetection element of Example 4 was manufactured in the same method as in Example 1, except that in the step of forming the photoelectric conversion film, the dispersion liquid 8 was used instead of the dispersion liquid 2.

(Example 5)

A photodetection element of Example 5 was manufactured in the same method as in Example 1, except that in the step of forming the photoelectric conversion film, the dispersion liquid 9 was used instead of the dispersion liquid 2.

(Example 6)

A photodetection element of Example 6 was manufactured in the same method as in Example 1, except that in the step of forming the photoelectric conversion film, the dispersion liquid 10 was used instead of the dispersion liquid 2.

(Example 7)

A photodetection element of Example 7 was manufactured in the same method as in Example 1, except that in the step of forming the photoelectric conversion film, the dispersion liquid 13 was used instead of the dispersion liquid 2.

(Example 8)

A photodetection element of Example 8 was manufactured in the same method as in Example 1, except that in the step of forming the photoelectric conversion film, the dispersion liquid 14 was used instead of the dispersion liquid 2.

(Example 9)

A photodetection element of Example 9 was manufactured in the same method as in Example 1, except that in the step of forming the photoelectric conversion film, the dispersion liquid 17 was used instead of the dispersion liquid 2.

(Example 10)

A photodetection element of Example 10 was manufactured in the same method as in Example 1, except that in the step of forming the photoelectric conversion film, the dispersion liquid 18 was used instead of the dispersion liquid 2.

(Example 11)

A photodetection element of Example 11 was manufactured in the same method as in Example 1, except that in the step of forming the photoelectric conversion film, the dispersion liquid 19 was used instead of the dispersion liquid 2.

(Example 12)

A photodetection element of Example 12 was manufactured in the same method as in Example 1, except that in the step of forming the photoelectric conversion film, the dispersion liquid 20 was used instead of the dispersion liquid 2.

(Example 13)

A photodetection element of Example 13 was manufactured in the same method as in Example 1, except that in the step of forming the photoelectric conversion film, the dispersion liquid 21 was used instead of the dispersion liquid 2.

(Example 14)

A photodetection element of Example 14 was manufactured in the same method as in Example 1, except that in the step of forming the photoelectric conversion film, the dispersion liquid 23 was used instead of the dispersion liquid 2.

(Example 15)

A photodetection element of Example 15 was manufactured in the same method as in Example 1, except that in

the step of forming the photoelectric conversion film, the dispersion liquid 24 was used instead of the dispersion liquid 2.

(Example 16)

A photodetection element of Example 16 was manufactured in the same method as in Example 1, except that in the step of forming the photoelectric conversion film, the dispersion liquid 26 was used instead of the dispersion liquid 2.

(Example 17)

A photodetection element of Example 17 was manufactured in the same method as in Example 1, except that in the step of forming the photoelectric conversion film, the dispersion liquid 27 was used instead of the dispersion liquid 2.

(Example 18)

A photodetection element of Example 18 was manufactured in the same method as in Example 1, except that in the step of forming the photoelectric conversion film, the dispersion liquid 6 was used instead of the dispersion liquid 2, and the application and drying of the dispersion liquid 6 were repeated 5 times to form a photoelectric conversion film having a thickness of 180 nm.

(Example 19)

An indium tin oxide (ITO) film having a thickness of about 100 nm was formed on a quartz glass by a sputtering method to form a first electrode layer.

Next, the ITO film (first electrode layer) was subjected to spin coating with a solution obtained by dissolving 1 g of zinc acetate dihydrate and 284 μl of ethanolamine in 10 ml of methoxyethanol at 3,000 rpm. Then, heating was carried out at 200°C for 30 minutes to form a sol-gel film of zinc oxide having a thickness of about 40 nm. Next, a step of dropwise adding the zinc oxide particle dispersion liquid 1 onto the sol-gel film, carrying out spin coating at 2,500 rpm, and carrying out heating at 70°C for 30 minutes was carried out twice. Then, using UVO-CLEANER MODEL 144AX-100 manufactured by Jelight Company Inc., an ultraviolet ozone treatment was carried out for 5 minutes under a condition of 30 $mW/cm^2$ (wavelength peak: 254 nm) to form a particle film of zinc oxide having a thickness of about 130 nm, whereby an electron transport layer was formed.

Next, the dispersion liquid 6 was added dropwise onto the electron transport layer, and then spin coating was carried out at 1,000 rpm, followed by drying at 60°C for 10 minutes to form a quantum dot film. The step of forming the quantum dot film was repeated 6 times to form a photoelectric conversion film having a thickness of 220 nm. Next, the photoelectric conversion film was dried in a glove box for 10 hours.

Next, a dichlorobenzene solution of PTB7 (poly({4,8-bis[(2-ethylhexyl)oxy]benzo[1,2-b:4,5-b']dithiophen-2,6-diyl}{3-fluoro-2-[(2-ethyl hexyl)carbonyl]thieno[3,4-b]thiophendiyl})) (concentration: 5 mg/mL) was applied onto the photoelectric conversion film by spin coating at 2,000 rpm, and then drying was carried out in a glove box for 10 hours to form a hole transport layer.

Next, a MoOs film having a thickness of 5 nm was formed on the hole transport layer by a vacuum deposition method through a metal mask, and then an Au film (the second electrode layer) having a thickness of 100 nm was formed to manufacture a photodiode-type photodetection element.

(Example 20)

A photodetection element of Example 20 was manufactured in the same method as in Example 19, except that in the step of forming the photoelectric conversion film, the dispersion liquid 27 was used instead of the dispersion liquid 6.

(Example 21)

A photodetection element of Example 21 was manufactured in the same method as in Example 1, except that in the step of forming the photoelectric conversion film, the dispersion liquid 28 was used instead of the dispersion liquid 2.

(Example 22)

A photodetection element of Example 22 was manufactured in the same method as in Example 1, except that in the step of forming the photoelectric conversion film, the dispersion liquid 29 was used instead of the dispersion liquid 2.

(Example 23)

A photodetection element of Example 23 was manufactured in the same method as in Example 1, except that in the step of forming the photoelectric conversion film, the dispersion liquid 30 was used instead of the dispersion liquid 2.

(Example 24)

A photodetection element of Example 24 was manufactured in the same method as in Example 1, except that in the step of forming the photoelectric conversion film, the dispersion liquid 31 was used instead of the dispersion liquid 2.

(Example 25)

A photodetection element of Example 25 was manufactured in the same method as in Example 1, except that in the step of forming the photoelectric conversion film, the dispersion liquid 32 was used instead of the dispersion liquid 2.

(Comparative Example 1)

A photodetection element of Comparative Example 1 was manufactured in the same method as in Example 1, except that in the step of forming the photoelectric conversion film, an octane dispersion liquid (concentration: 100 mg/mL, comparative dispersion liquid 1) of PbS quantum dots having a surface to which oleic acid was coordinated was used instead of the dispersion liquid 2.

<Evaluation>

The external quantum efficiency (EQE) and the dark current of the manufactured photodetection elements were evaluated by using a semiconductor parameter analyzer (C4156, manufactured by Agilent Technologies, Inc.).

First, the current-voltage characteristics (I-V characteristics) were measured while sweeping the voltage from 0 V to -2 V in a state of not carrying out irradiation with light, and the dark current value was evaluated. Here, regarding the dark current value, a value at -1V was used as the dark current value. Subsequently, the I-V characteristics were measured while sweeping the voltage from 0 V to -2 V in a state of carrying out irradiation with monochromatic light having a wavelength of 940 nm, 1,200 nm, 1,400 nm, or 1,600 nm. A value obtained by subtracting the dark current value from the current value in a state where -1 V was applied was defined as the photocurrent value, and the external quantum efficiency (EQE) was calculated from the photocurrent value.

It is noted that in Examples 1 to 20 and 24 and Comparative Example 1, the external quantum efficiency and the dark current were measured by carrying out irradiation with monochromatic light having a wavelength of 940 nm. In addition, in Example 21, the external quantum efficiency and the dark current were measured by carrying out irradiation with monochromatic light having a wavelength of 1,200 nm. In addition, in Examples 22 and 25, the external quantum efficiency and the dark current were measured by carrying out irradiation with monochromatic light having a wavelength of 1,400 nm. In addition, in Example 23, the external quantum efficiency and the dark current were measured by carrying out irradiation with monochromatic light having a wavelength of 1,600 nm.

[Table 2]

| | Photoelectric conversion layer | | Electron transport layer | EQE (%) | Dark current (nA/cm$^2$) |
|---|---|---|---|---|---|
| | Dispersion liquid used | Film thickness (nm) | | | |
| Example 1 | Dispersion liquid 2 | 220 nm | Titanium oxide film | 51.9 | 36 |
| Example 2 | Dispersion liquid 6 | 220 nm | Titanium oxide film | 52.2 | 25 |
| Example 3 | Dispersion liquid 7 | 220 nm | Titanium oxide film | 52.1 | 32 |
| Example 4 | Dispersion liquid 8 | 220 nm | Titanium oxide film | 45.2 | 120 |
| Example 5 | Dispersion liquid 9 | 220 nm | Titanium oxide film | 51.5 | 35 |
| Example 6 | Dispersion liquid 10 | 220 nm | Titanium oxide film | 529 | 21 |
| Example 7 | Dispersion liquid 13 | 220 nm | Titanium oxide film | 51.5 | 24 |
| Example 8 | Dispersion liquid 14 | 220 nm | Titanium oxide film | 48.9 | 90 |

(continued)

| | Photoelectric conversion layer | | Electron transport layer | EQE (%) | Dark current (nA/cm²) |
|---|---|---|---|---|---|
| | Dispersion liquid used | Film thickness (nm) | | | |
| Example 9 | Dispersion liquid 17 | 220 nm | Titanium oxide film | 43.2 | 99 |
| Example 10 | Dispersion liquid 18 | 220 nm | Titanium oxide film | 52.2 | 10 |
| Example 11 | Dispersion liquid 19 | 220 nm | Titanium oxide film | 51.9 | 8 |
| Example 12 | Dispersion liquid 20 | 220 nm | Titanium oxide film | 51.2 | 6 |
| Example 13 | Dispersion liquid 21 | 220 nm | Titanium oxide film | 528 | 21 |
| Example 14 | Dispersion liquid 23 | 220 nm | Titanium oxide film | 56.0 | 11 |
| Example 15 | Dispersion liquid 24 | 220 nm | Titanium oxide film | 52.2 | 25 |
| Example 16 | Dispersion liquid 26 | 220 nm | Titanium oxide film | 25.1 | 34 |
| Example 17 | Dispersion liquid 27 | 220 nm | Titanium oxide film | 28.6 | 30 |
| Example 18 | Dispersion liquid 6 | 180 nm | Titanium oxide film | 43.0 | 27 |
| Example 19 | Dispersion liquid 6 | 220 nm | Particle film of zinc oxide | 53.0 | 26 |
| Example 20 | Dispersion liquid 27 | 220 nm | Particle film of zinc oxide | 29.5 | 22 |
| Example 21 | Dispersion liquid 28 | 180 nm | Titanium oxide film | 52.3 | 570 |
| Example 22 | Dispersion liquid 29 | 160 nm | Titanium oxide film | S31 | 1100 |
| Example 23 | Dispersion liquid 30 | 130 nm | Titanium oxide film | 51.9 | 1230 |
| Example 24 | Dispersion liquid 31 | 220 nm | Titanium oxide film | 200 | 71 |
| Example 25 | Dispersion liquid 32 | 220 nm | Titanium oxide film | 5.7 | 1100 |
| Comparative Example 1 | Comparative dispersion liquid 1 | 220 nm | Titanium oxide film | 0.1 | 3 |

As shown in the above table, it was confirmed that the external quantum efficiency (EQE) of the photodetection element of Example was significantly high as compared with the external quantum efficiency (EQE) of Comparative Example 1.

In a case of producing an image sensor using the photodetection element obtained in Examples by using an optical filter produced according to the method described in WO2016/186050A and WO2016/190162A and by a publicly known method and together with a publicly known method, it is possible to obtain an image sensor having good visibility and infrared imaging performance.

Explanation of References

1: photodetection element
11: first electrode layer
12: second electrode layer
13: photoelectric conversion layer
21: electron transport layer
22: hole transport layer

**Claims**

**1.** A dispersion liquid comprising:

a quantum dot having a band gap of 1.35 eV or less;
two or more kinds of ligands; and
a solvent,
wherein at least one of the two or more kinds of ligands is a ligand having a boiling point of 200°C or lower.

**2.** The dispersion liquid according to claim 1,
wherein a difference between a boiling point of a ligand having a lowest boiling point and a boiling point of a ligand having a highest boiling point among the two or more kinds of ligands is 30°C or higher.

**3.** The dispersion liquid according to claim 1 or 2,
wherein the ligand having a boiling point of 200°C or lower is an organic ligand.

**4.** The dispersion liquid according to claim 3,
wherein the organic ligand is a compound having at least one functional group selected from the group consisting of a carboxy group, a mercapto group, an amino group, a phospho group, a phosphonate group, a sulfonamide group, a sulfonimide group, and a sulfo group.

**5.** The dispersion liquid according to claim 1 or 2,
wherein the dispersion liquid contains a ligand having a boiling point of 200°C or lower and a ligand having a boiling point of higher than 200°C.

**6.** The dispersion liquid according to claim 5,
wherein the ligand having a boiling point of higher than 200°C is an organic ligand.

**7.** The dispersion liquid according to claim 6,
wherein the organic ligand is a compound having at least one functional group selected from the group consisting of a carboxy group, a mercapto group, an amino group, a phospho group, a phosphonate group, a sulfonamide group, a sulfonimide group, and a sulfo group.

**8.** The dispersion liquid according to claim 5,
wherein the ligand having a boiling point of higher than 200°C is an inorganic ligand.

**9.** The dispersion liquid according to claim 1 or 2,
wherein a content of the quantum dot in a component obtained by removing the solvent and the ligand from the dispersion liquid is 50% by mass or more.

**10.** The dispersion liquid according to claim 1 or 2,
wherein the quantum dot contains at least one kind of atom selected from the group consisting of Ga, Ge, As, Se, In, Sn, Sb, Te, Pb, Bi, Ag, Cu, and Hg.

**11.** The dispersion liquid according to claim 1 or 2,
wherein the quantum dot contains at least one kind of atom selected from the group consisting of Ga, As, Se, In, Sb, Te, and Bi.

**12.** The dispersion liquid according to claim 1 or 2,
wherein the quantum dot has a maximal absorption in terms of absorbance in a wavelength range of 900 to 1,700 nm.

**13.** The dispersion liquid according to claim 1 or 2,
wherein the dispersion liquid is used for a photoelectric conversion layer of an infrared sensor.

**14.** A manufacturing method for a quantum dot film, comprising:

applying the dispersion liquid according to claim 1 or 2 onto a support to form a composition layer; and
drying the composition layer.

**15.** A manufacturing method for a photodetection element, comprising:
the manufacturing method for a quantum dot film according to claim 14.

**16.** A manufacturing method for an image sensor, comprising:
the manufacturing method for a quantum dot film according to claim 14.

FIG. 1

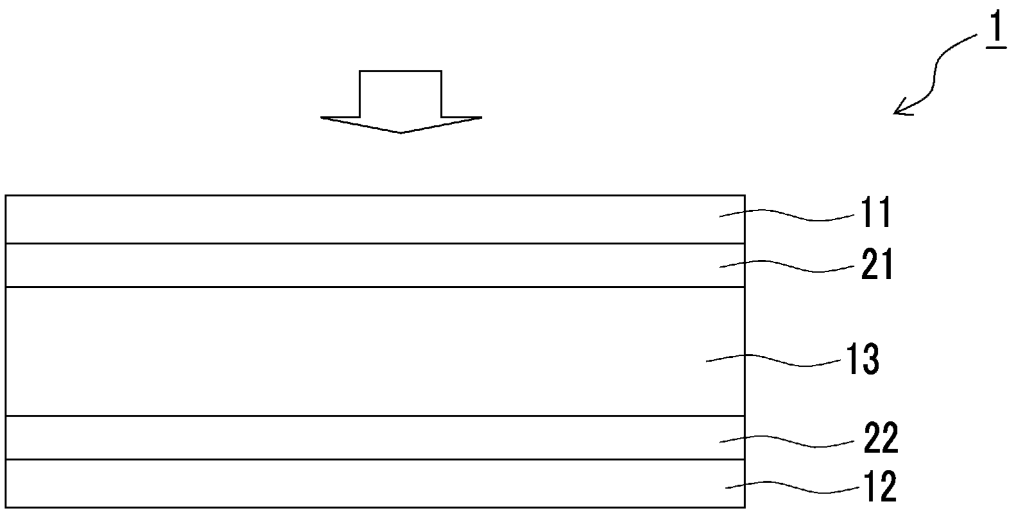

**INTERNATIONAL SEARCH REPORT**

International application No.
**PCT/JP2023/004271**

**A. CLASSIFICATION OF SUBJECT MATTER**

***H01L 31/0248***(2006.01)i
FI: H01L31/08 K

According to International Patent Classification (IPC) or to both national classification and IPC

**B. FIELDS SEARCHED**

Minimum documentation searched (classification system followed by classification symbols)

H01L31/0248

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2019/150989 A1 (SONY CORPORATION) 08 August 2019 (2019-08-08) claims 1, 4-6, paragraphs [0001], [0033], [0164], [0173] | 1-16 |
| Y | US 2017/0373205 A1 (NOKIA TECHNOLOGIES OY) 28 December 2017 (2017-12-28) paragraph [0096] | 1-16 |
| A | JP 2020-041080 A (TOYO INK SC HOLDINGS CO LTD) 19 March 2020 (2020-03-19) entire text, all drawings | 1-16 |
| A | CN 211480067 U (CHONGQING INSTITUTE OF GREEN AND INTELLIGENT TECHNOLOGY, CHINESE ACADEMY OF SCIENCES) 11 September 2020 (2020-09-11) entire text, all drawings | 1-16 |

☐ Further documents are listed in the continuation of Box C.   ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **10 March 2023** | **20 March 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/004271**

| Patent document cited in search report | Publication date (day/month/year) | Patent family member(s) | Publication date (day/month/year) |
|---|---|---|---|
| WO 2019/150989 A1 | 08 August 2019 | US 2021/0057168 A1<br>claims 1, 4-6, paragraphs [0001], [0055], [0185], [0194]<br>CN 111630668 A | |
| US 2017/0373205 A1 | 28 December 2017 | WO 2016/102745 A1<br>EP 3038168 A1<br>CN 107112372 A | |
| JP 2020-041080 A | 19 March 2020 | (Family: none) | |
| CN 211480067 U | 11 September 2020 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2020150251 A
- JP 5949567 B
- JP 2001291534 A
- JP 2013077009 A
- JP 2014130173 A
- JP 2014130338 A
- WO 2015166779 A
- WO 2016178346 A
- WO 2016190162 A
- WO 2018016232 A
- JP 2016177079 A
- JP 2014130332 A
- WO 2016027798 A
- WO 2016186050 A
- WO 2016035695 A
- JP 6248945 B
- WO 2019021767 A
- JP 2017067963 A
- JP 6506529 B
- JP 2014130344 A
- JP 2018010296 A
- WO 2019039172 A
- WO 2019017280 A
- WO 2018092600 A